# EUROPEAN PATENT SPECIFICATION

(11) **EP 4 242 332 B1**
(45) Date of publication and mention of the grant of the patent: **29.01.2025**
(21) Application number: 23157653.9
(22) Date of filing: 20.02.2023
(51) Int. Cl.: C22C 19/05, C22C 19/07, C23C 4/073, F01D 5/28

(54) **BORIDE-REINFORCED ALUMINUM-CONTAINING HIGH ENTROPY ALLOY COMPOSITION**
BORIDVERSTÄRKTE ALUMINIUMHALTIGE LEGIERUNGSZUSAMMENSETZUNG MIT HOHER ENTROPIE
COMPOSITION D'ALLIAGE À ENTROPIE ÉLEVÉE CONTENANT DE L'ALUMINIUM RENFORCÉ PAR DU BORURE

(30) Priority: 10.03.2022 IN 202211013112
(43) Date of publication of application: 13.09.2023
(73) Proprietor: General Electric Technology GmbH, 5400 Baden (CH)
(72) Inventor: HANUM, Sathisha Chikkabikkodu, 560066 Bengaluru (IN); NAYAK, Mohandas, 560066 Bengaluru (IN); PABLA, Surinder Singh, Greenville, 29615 (US); DASAN, Biju, 560066 Bengaluru (IN)
(74) Representative: Novagraaf Group

(56) References cited:
- CN-C- 100 507 067
- JP-A- 2005 206 930
- JP-A- 2005 213 605
- US-A1- 2017 016 123
- HUANG CHUANBING ET AL: "Friction properties of high temperature boride coating under dry air and water vapor ambiences", CERAMICS INTERNATIONAL, ELSEVIER, AMSTERDAM, NL, vol. 40, no. 8, 26 April 2014 (2014-04-26), pages 12403 - 12411, XP028862510, ISSN: 0272-8842, DOI: 10.1016/J.CERAMINT.2014.04.091

## Description

### BACKGROUND

The invention relates generally to a composition, a machine component coated with the same, and a method of coating the machine component. In particular, the invention relates generally to a boride-reinforced aluminum-containing high entropy alloy (B-AlHEA) composition, a machine component coated with the same, and a method of coating the machine component.

Gas turbine systems are mechanisms for converting potential energy, in the form of fuel, to thermal energy and then to mechanical energy for use in propelling aircraft, generating electric power, pumping fluids etc. Gas turbine systems include a compressor section for supplying a flow of compressed combustion air, a combustor section for burning fuel in the compressed combustion air, and a turbine section for extracting thermal energy from the combustion air and converting that energy into mechanical energy in the form of a rotating shaft. One available avenue for improving efficiency of gas turbine systems is use of higher operating temperatures.

However, metallic materials such as alloys used in gas turbine systems may be near the upper limits of their thermal stability at higher gas turbine operating temperatures. Modern high efficiency combustion gas turbine systems may have firing temperatures that exceed about 1,000°C, and even higher firing temperatures are expected as the demand for more efficient engines continues. Many components that form the "hot gas path" combustor and turbine sections are directly exposed to aggressive hot combustion gasses, for example, the combustor liner, the transition duct between the combustion and turbine sections, and the turbine stationary vanes and rotating blades and surrounding ring segments. In the hottest temperature portions of gas turbine systems, some metallic materials may be exposed to temperatures above their melting points.

In addition to thermal stresses discussed above, these and other components of gas turbine systems exposed to higher temperatures may experience mechanical stresses and loads that may cause mechanical wear to the components. For example, bucket interlocks of the gas turbine systems may be subjected to relatively high temperature (e.g., greater than 700°C, 800°C, or 900°C) fretting motion, such as when the respective buckets lock up due to centrifugal and aerodynamic forces. The bucket interlocks may be subjected to fluttering, for example, during startup of the gas turbine, which may cause mechanical contact along the bucket interlocks.

Coatings are often applied to high temperature operating components, such as but are not limited to those in gas turbine systems. For example, ceramic materials are generally used as a thermal barrier coating. However, ceramic materials may still exhibit instability and decompose at relatively high temperatures, for example, above 900°C, thus not providing the full desired thermal barrier coating protection.

On the other hand, coatings used to provide improved mechanical wear resistance, for example, coating formed with Tribaloy^{®} T-800^{®} (Deloro Stellite Holdings Corporation, a Kennametal Company, Saint Louis, MO), a commercial alloy, tends to oxidize or gall at temperatures greater than 800°C, making them unsuitable for certain sections of engines that operate at temperatures greater than 800°C. Huang et al. "Friction properties of high temperature boride coating under dry air and water vapor ambiences", Ceramics International, Elsevier, vol. 40, no. 8, 26 April 2014, p. 12403-12411 relates to NiCoCrAlY/ZrB2-B4C composite coatings prepared by atmospheric plasma spraying using a clad powder and their microstructure, phase composition and mechanical properties were characterized.

### BRIEF DESCRIPTION

Certain embodiments are summarized below. These embodiments are not intended to limit the scope of the present disclosure, but rather these embodiments are intended only to provide a brief summary of possible forms of the disclosure. Indeed, the present system and method may encompass a variety of forms that may be similar to or different from the embodiments set forth below.

All aspects, examples and features mentioned below can be combined in any technically possible way.

An aspect of the invention provides a composition, comprising: a CoNiCrAlY alloy, wherein three or more elements of the CoNiCrAlY alloy are present in equimolar amounts, one of the three or more elements being aluminum (Al), and wherein a molar fraction of Al is between about 0.20 and about 0.25; a transition metal boride including at least one of: cobalt boride (Co₂B), titanium boride (TiB₂), zirconium boride (ZrB₂), tantalum boride (TaB₂), niobium boride (NiB₂), or molybdenum boride (Mo₂B); and a refractory alloy. When the refractory alloy includes molybdenum niobium (MoNb), the composition includes, based on the total weight of the composition: between about 10% and about 70% by weight the CoNiCrAlY alloy; between about 20% and about 60% by weight the transition metal boride; and between about 0.5% and about 10% by weight MoNb. When the refractory alloy includes M-Mo-Cr-Si, where M includes Ni or Co, the composition includes, based on the total weight of the composition: between about 30% and about 70% by weight the CoNiCrAlY alloy; between about 20% and about 40% by weight the transition metal boride; and between about 20% and about 60% by weight the refractory alloy.

Another aspect of the invention includes any of the preceding aspects, and wherein the composition includes a powder blend having an average particle size between about 0.1 microns (µm) and about 120 µm.

Another aspect of the invention includes any of the preceding aspects, and wherein the composition is configured to form a coating, the coating having a microstructure including: a sigma phase matrix including a plurality of particles of the CoNiCrAlY alloy; a laves phase uniformly dispersed in the sigma phase matrix, the laves phase including a plurality of particles of the transition metal boride; and a beta phase dispersed in the sigma phase matrix, the beta phase including a plurality of particles of the refractory alloy.

Another aspect of the invention includes any of the preceding aspects, and wherein the coating further includes an aluminum oxide layer formed above and across a region, the region including the sigma phase matrix, the laves phase, and the beta phase.

Another aspect of the invention includes any of the preceding aspects, and wherein the aluminum oxide layer has a thickness of less than about 20 microns (µm).

Another aspect of the invention provides a machine component comprising: a substrate having a coating thereon, the coating including: a CoNiCrAlY alloy, wherein three or more elements of the CoNiCrAlY alloy are present in equimolar amounts, one of the three or more elements being Al, and wherein a molar fraction of Al is between about 0.20 and about 0.25; a transition metal boride including at least one of: cobalt boride (Co₂B), titanium boride (TiB₂), zirconium boride (ZrB₂), tantalum boride (TaB₂), niobium boride (NiB₂), or molybdenum boride (Mo₂B); and a refractory alloy. When the refractory alloy includes molybdenum niobium (MoNb), the composition includes, based on the total weight of the composition: between about 10% and about 70% by weight the CoNiCrAlY alloy; between about 20% and about 60% by weight the transition metal boride; and between about 0.5% and about 10% by weight MoNb. When the refractory alloy includes M-Mo-Cr-Si, where M includes Ni or Co, the composition includes, based on the total weight of the composition: between about 30% and about 70% by weight the CoNiCrAlY alloy; between about 20% and about 40% by weight the transition metal boride; and between about 20% and about 60% by weight the refractory alloy.

Another aspect of the invention includes any of the preceding aspects, and wherein the composition includes a powder blend having an average particle size between about 0.1 microns (µm) and about 120 µm.

Another aspect of the invention includes any of the preceding aspects, and wherein the coating has a microstructure including: a sigma phase matrix including a plurality of particles of the CoNiCrAlY alloy; a laves phase substantially uniformly dispersed in the sigma phase matrix, the laves phase including a plurality of particles of the transition metal boride; and a beta phase dispersed in the sigma phase matrix, the beta phase including a plurality of particles of the refractory alloy.

Another aspect of the invention includes any of the preceding aspects, and wherein the coating further includes an aluminum oxide layer formed above and across a region, the region including the sigma phase matrix, the laves phase, and the beta phase.

Another aspect of the disclosure which is not claimed provides a method of coating a machine component, the method comprising: providing a composition that includes: a CoNiCrAlY alloy, wherein three or more elements of the CoNiCrAlY alloy are present in equimolar amounts, one of the three or more elements being Al, and wherein a molar fraction of Al is between about 0.20 and about 0.25; a transition metal boride including at least one of: cobalt boride (Co₂B), titanium boride (TiB₂), zirconium boride (ZrB₂), tantalum boride (TaB₂), niobium boride (NiB₂), or molybdenum boride (Mo₂B); and a refractory alloy; and applying the composition to a substrate of the machine component.

Another aspect of the disclosure, which is not claimed, includes any of the preceding aspects, and wherein the applying the composition includes forming a coating on the machine component, wherein the coating has a microstructure that includes: a sigma phase matrix including a plurality of particles of the CoNiCrAlY alloy; a laves phase uniformly dispersed in the sigma phase matrix, the laves phase including a plurality of particles of the transition metal boride; and a beta phase dispersed in the sigma phase matrix, the beta phase including a plurality of particles of the refractory alloy.

Another aspect of the disclosure, which is not claimed, includes any of the preceding aspects, and wherein the method further includes: thermally treating the coating; and forming an aluminum oxide layer above and across a region, the region including the sigma phase matrix, the laves phase, and the beta phase.

Two or more aspects described in this disclosure, including those described in this summary section, may be combined to form implementations not specifically described herein.

The details of one or more implementations are set forth in the accompanying drawings and the description below. Other features, objects and advantages will be apparent from the description and drawings, and from the claims.

### BRIEF DESCRIPTION OF THE DRAWINGS

These and other features of this disclosure will be more readily understood from the following detailed description of the various aspects of the disclosure taken in conjunction with the accompanying drawings that depict various embodiments of the disclosure, in which:
FIG. 1 is a table of various B-AlHEA compositions with constituents in weight percentage (wt%) based on the total weight of the B-AlHEA composition, according to embodiments of the disclosure;
FIG. 2 is a schematic diagram of a process for forming a B-AlHEA composition and forming a coating from the B-AlHEA composition on a substrate of a machine component, according to embodiments of the disclosure; and
FIG. 3 is a schematic diagram of a microstructure of a coating formed from a B-AlHEA composition, according to embodiments of the disclosure; and
FIG. 4 is a schematic sectional view of a machine component with a coating formed thereon from a B-AlHEA composition, according to embodiments of the disclosure; and
FIG. 5 is a flow diagram of a method of coating a machine component with a B-AlHEA coated thereon, according to embodiments of the disclosure.

It is noted that the drawings of the disclosure are not necessarily to scale. The drawings are intended to depict only typical aspects of the disclosure and therefore should not be considered as limiting the scope of the disclosure. In the drawings, like numbering represents like elements between the drawings.

### DETAILED DESCRIPTION

As an initial matter, in order to clearly describe the subject matter of the current disclosure, it will become necessary to select certain terminology when referring to and describing relevant machine components within the current disclosure. To the extent possible, common industry terminology will be used and employed in a manner consistent with its accepted meaning. Unless otherwise stated, such terminology should be given a broad interpretation consistent with the context of the present application and the scope of the appended claims. Those of ordinary skill in the art will appreciate that often a particular component may be referred to using several different or overlapping terms. What may be described herein as being a single part may include and be referenced in another context as consisting of multiple components. Alternatively, what may be described herein as including multiple components may be referred to elsewhere as a single part.

In addition, several descriptive terms may be used regularly herein, and it should prove helpful to define these terms at the onset of this section. These terms and their definitions, unless stated otherwise, are as follows.

The terminology used herein is for the purpose of describing particular embodiments only and is not intended to be limiting of the disclosure. As used herein, the singular forms "a", "an" and "the" are intended to include the plural forms as well, unless the context clearly indicates otherwise. The terms "first", "second", and "third" may be used interchangeably to distinguish one component from another and are not intended to signify location or importance of the individual components. It will be further understood that the terms "comprises" and/or "comprising," when used in this specification, specify the presence of stated features, integers, steps, operations, elements, and/or components but do not preclude the presence or addition of one or more other features, integers, steps, operations, elements, components, and/or groups thereof. "Optional" or "optionally" means that the subsequently described event or circumstance may or may not occur or that the subsequently describe component or element may or may not be present, and that the description includes instances where the event occurs or the component is present and instances where it does not or is not present.

Where an element or layer is referred to as being "on," "engaged to," "connected to" or "coupled to" another element or layer, it may be directly on, engaged to, connected to, or coupled to the other element or layer, or intervening elements or layers may be present. In contrast, when an element is referred to as being "directly on," "directly engaged to," "directly connected to" or "directly coupled to" another element or layer, there may be no intervening elements or layers present. Other words used to describe the relationship between elements should be interpreted in a like fashion (e.g., "between" versus "directly between," "adjacent" versus "directly adjacent," etc.). As used herein, the term "and/or" includes any and all combinations of one or more of the associated listed items.

As discussed above, gas turbine systems convert potential energy to thermal energy and then to mechanical energy for use. Improving efficiency of a gas turbine is desirable and that improvement can be achieved by operating the gas turbine at higher temperatures. However, metallic materials used in gas turbines, especially at higher temperatures associated with hot gas path components may be near the upper limits of their thermal stability at gas turbine operating conditions. In the hottest portions of gas turbines, some metallic materials may even be exposed to temperatures above their melting points.

Currently available approaches may not be suitable for certain sections of gas turbine systems that operate at ultra-high temperatures (e.g., greater than 800°C, 900°C, 1000°C, 1 100°C, 1200°C, 1300°C, or 1400°C, etc.). For example, when a gas turbine component coated with Tribaloy^{®} T-800^{®} alloy is exposed to temperatures greater than 800°C, chromium (Cr) and cobalt (Co) elements of the T-800^{®} alloy are readily oxidized to form a thick layer of oxide scale including Cr and/or Co oxide. As oxide scale continues to form, more and more Cr and Co are consumed, leading to decreased amounts of the laves phases of T-800^{®}. Laves phases of T-800^{®} include Co₂Mo₂Si and CoMoSi and are believed to impart wear resistance of the coating. As a result of oxidation, wear resistance of T-800^{®} alloy coatings may decrease.

The present invention provides a composition that includes a boride-reinforced high entropy alloy (B-A1HEA) and a coating formed from the same. Compositions of the present invention and coatings formed therefrom can provide enhanced oxidation and wear resistance under ultra-high temperatures, for example, temperatures greater than 800°C, 900°C, 1000°C, 1100°C, 1200°C, 1300°C, or 1400°C, etc. Such compositions and coatings may be useful for hot gas path components in turbine machinery.

High entropy alloys (HEAs) provide a new type of design framework for developing alloys with enhanced high temperature capability. Typical high entropy alloys may include five or more metals of equimolar amounts/concentrations and may mainly include a single-phase structure, such as simple solid solutions (SSSs). HEAs were developed based on an assumption that a high entropy of mixing may help suppress the formation of intermetallic phases and stabilize a multicomponent single-phase solid solution of metals. While HEAs have potential for enhanced high temperature capability, by the nature of their design principles/assumptions, conventional HEAs may lack or have a low presence of intermetallic phases, including laves phases that may impart wear resistance to the coating.

The present invention provides a new class of composition of a boride-reinforced aluminum (Al)-containing HEA (B-AlHEA), that is, an aluminum (Al)-containing HEA (AlHEA) reinforced by transition metal boride(s). Compositions of the invention can have enhanced high temperature capability, for example, enhanced oxidation and wear resistance. In certain embodiments, B-AlHEA includes: a CoNiCrAlY alloy, where three or more elements of the CoNiCrAlY alloy are present in equimolar amounts, one of the three or more elements being Al, and where a molar fraction of Al is between about 0.20 and about 0.25; a transition metal boride including at least one of:
cobalt boride (Co₂B), titanium boride (TiB₂), zirconium boride (ZrB₂), tantalum boride (TaB₂), niobium boride (NiB₂), or molybdenum boride (Mo₂B); and a refractory alloy.

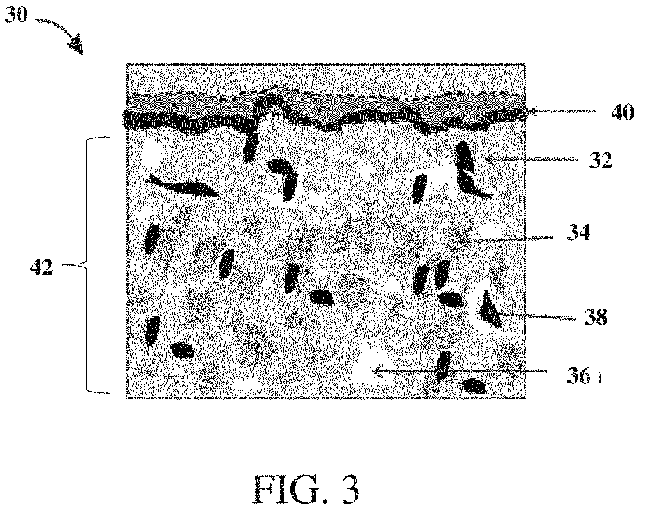

B-AlHEA can provide enhanced oxidation resistance. Aluminum (Al) is present in CoNiCrAlY alloy as one of the three or more element in equimolar amounts and in a relatively high molar fraction (e.g., molar fraction of Al is about 0.20-0.25). When a machine component is coated with B-AlHEA and subjected to an ultra-high temperature environment (the ultra-high temperature in the disclosure refers to a temperature greater than 800°C, 900°C, 1000°C, 1100°C, 1200°C, 1300°C, or 1400°C, etc.), an entropy state of the alloy would favor formation of aluminum oxide over formation of chromium (Cr) and/or cobalt (Co) oxides. In other words, Al would be more readily oxidized than other metal elements, such as Cr and Co, in the coating formed with B-AlHEA composition. The resulting aluminum oxide (Al₂O₃) layer (Al oxide layer) is an oxidation layer that acts as a protective oxide layer. The protective oxide layer may prevent further destruction of intermetallic phases, including laves phases underneath the Al oxide layer in the coating microstructure, as will be discussed in detail with respect to FIG. 3. Therefore, the Al oxide layer resulting from coating with B-AlHEA may offer benefits of enhancing both oxidation resistance (for example, by minimizing oxidations of Cr and/or Co metals) and wear resistance (for example, by protecting laves phases underneath the Al oxide layer in the coating microstructure).

The A1HEA composition of the invention is reinforced by additives, such as but not limited to, transition metal boride(s). Without being bound by the theory, by reinforcing A1HEA with transition metal borides and forming B-AlHEA, more secondary hardening phases, such as laves phases including a plurality of particles of the transition metal borides, may be introduced into the microstructure of the B-AlHEA, thereby further enhancing the wear resistance of the B-AlHEA under ultra-high temperatures. In embodiments, the transition metal borides may include at least one of: cobalt boride (Co₂B), titanium boride (TiB₂), zirconium boride (ZrB₂), tantalum boride (TaB₂), niobium boride (NiB₂), or molybdenum boride (Mo₂B).

B-AlHEA of the invention includes a refractory alloy. The refractory alloy, in combination with other constituents of B-AlHEA, can impart more hardening phases to the microstructure of B-AlHEA, thereby further enhancing wear resistance. In certain embodiments, the refractory alloy includes molybdenum niobium (MoNb). In some embodiments, the refractory alloy includes M-Mo-Cr-Si, where M includes Ni or Co, or a combination thereof. In some embodiments, the M-Mo-Cr-Si alloy may include Co-Mo-Cr-Si. In embodiments, the M-Mo-Cr-Si alloy may include T-800^{®}.

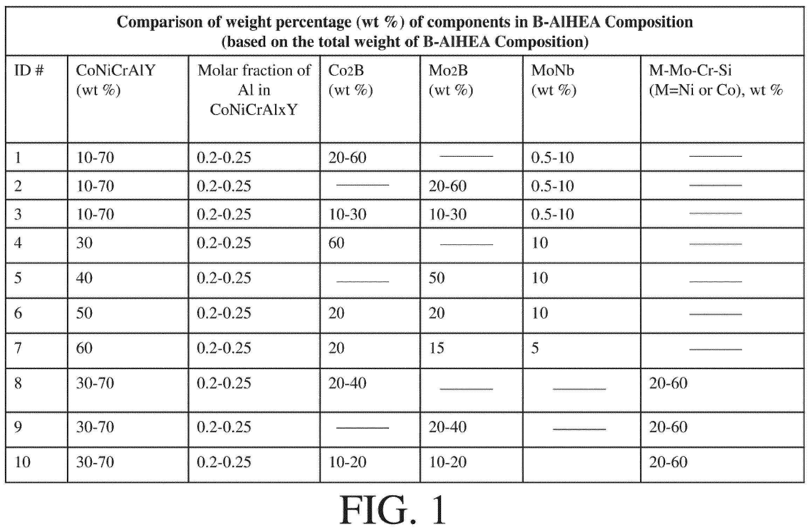

FIG. 1 is a table of various B-AlHEA compositions, as embodied by the invention. B-AlHEA compositions include a CoNiCrAlY alloy, where three or more elements of the CoNiCrAlY alloy are present in equimolar amounts, one of the three or more elements being Al, and where a molar fraction of Al is between about 0.20 and about 0.25. B-AlHEA compositions further include a transition metal boride including at least one of: cobalt boride (Co₂B), titanium boride (TiB₂), zirconium boride (ZrB₂), tantalum boride (TaB₂), niobium boride (NiB₂), or molybdenum boride (Mo₂B). Additionally, B-AlHEA compositions include a refractory alloy. The refractory alloy is molybdenum niobium (MoNb), or M-Mo-Cr-Si, where M includes Ni or Co, or a combination thereof. In some embodiments, M-Mo-Cr-Si alloy may include Co-Mo-Cr-Si. In embodiments, the M-Mo-Cr-Si alloy may include T-800^{®}. It is to be understood that the table of FIG. 1 serves the purpose of describing certain embodiments only and is not intended to be limiting of the disclosure. For example, while certain weight percentage of the CoNiCrAlY alloy are included in the examples for illustration purposes, it is to be understood that other weight percentage ranges of the CoNiCrAlY alloy as disclosed in detail below, may be used in other embodiments. In addition, while Co₂B and Mo₂B are listed in FIG. 1 for illustration purposes, other transition metal borides, for example, titanium boride (TiB₂), zirconium boride (ZrB₂), tantalum boride (TaB₂), or niobium boride (NiB₂), may replace Co₂B and/or Mo₂B to form other embodiments of B-AlHEA compositions.

In certain embodiments, the elements of the CoNiCrAlY alloy present in equimolar amounts may be cobalt (Co), nickel (Ni), chromium (Cr), aluminum (Al), and yttrium (Y) in a molar ratio of 1:1:1:1:1. However, it is to be understood that the formula CoNiCrAlY used in the disclosure is a generic formula and is not limited to the embodiment where the molar ratio between elements Co:Ni:Cr:Al:Y is 1:1:1:1:1. Rather, the formula CoNiCrAlY may also include embodiments where the molar ratio between Co:Ni:Cr:Al:Y may be adjusted as long as three or more elements of the CoNiCrAlY alloy are present in equimolar amounts, one of the three or more elements being Al, and where a molar fraction of Al is between about 0.20 and about 0.25. For example, in some embodiments, the three or more elements of the CoNiCrAlY alloy present in equimolar amounts may be Co, Ni, and Al, and the formula may be CoₐNi_{b}Cr_{c}Al_{d}Yₑ where a, b, d has the same value and in a range of about 0.20 and about 0.25, and where a+b+c+d+e=1. In other embodiments, the three or more elements of the CoNiCrAlY alloy present in equimolar amounts may be Ni, Cr, and Al, and the formula may be CoₐNi_{b}Cr_{c}Al_{d}Yₑ where b, c, d has the same value and in a range of about 0.20 and about 0.25, and where a+b+c+d+e=1. The three or more elements of the CoNiCrAlY alloy present in equimolar amounts may also be Co, Cr, and Al, and the formula may be CoₐNi_{b}Cr_{c}Al_{d}Yₑ where a, c, d has the same value and in a range of about 0.20 and about 0.25, and where a+b+c+d+e=1. In some embodiments, the three or more elements of the CoNiCrAlY alloy present in equimolar amounts may be selected from cobalt (Co), nickel (Ni), chromium (Cr), aluminum (Al), and yttrium (Y), and the formula may be CoₐNi_{b}Cr_{c}Al_{d}Yₑ where each of a, b, c, d and e is about 0.20. The molar fraction of Al in the CoNiCrAlY may be about 0.20, 0.21, 0.22, 0.23, 0.24, 0.25, including ranges between any two numerical values in the list.

The weight percentage of the CoNiCrAlY alloy in the composition may be between about 10% and about 70%. In some embodiments, weight percentage of the CoNiCrAlY alloy in the composition may be between about 10%, about 15%, about 20%, about 25%, about 30%, about 35%, about 40%, about 45%, about 50%, about 55%, about 60%, about 65%, about 70%, including ranges between any two of the above values. For example, in some embodiments, the CoNiCrAlY alloy may be present in between about 10% and about 70% by weight, or about 20% and about 60% by weight, or about 40% and about 70% by weight, based on the total weight of the B-AlHEA composition.

The transition metal boride(s) is present in between about 20% and about 60% by weight in the composition. In embodiments, a transition metal boride including at least one of: cobalt boride (Co₂B), titanium boride (TiB₂), zirconium boride (ZrB₂), tantalum boride (TaB₂), niobium boride (NiB₂), or molybdenum boride (Mo₂B). In embodiments, as illustrated as non-limiting examples in FIG. 1, transition metal boride(s) may be at least one of CozB and Mo₂B, for example, Co₂B or Mo₂B or a combination thereof. In embodiments, the weight percentage of the at least one of CozB and Mo₂B in the composition may be between about 20% and about 60%, such as about 20%, about 25%, about 30%, about 35%, about 40%, about 45%, about 50%, about 55%, about 60%, including ranges between any two of the above values. For example, in some embodiments, the boride(s) may also be present in between about 30% and about 50% by weight, or about 20% and about 40% by weight in the B-AlHEA composition.

In embodiments, the refractory alloy is MoNb or M-Mo-Cr-Si, where M includes Ni or Co. For example, the refractory alloy MoNb is present in between about 0.5% and about 10% by weight based on the total weight of the B-AlHEA composition. In embodiments, the weight percentage of MoNb in the composition may be about 0.5%, about 1%, about 2%, about 3%, about 4%, about 5%, about 10%, about 15%, about 20%, about 25%, about 30%, about 35%, about 40%, about 45%, including ranges between any two of the above values. In other embodiments, the refractory alloy is M-Mo-Cr-Si, where M includes Ni or Co. For example, the refractory alloy M-Mo-Cr-Si is present in between about 20% and about 60% by weight, about 30% and about 50% by weight, or about 20% and about 40% by weight in the B-AlHEA composition. In embodiments, the weight percentage of MoNb in the composition may be about 20%, about 25%, about 30%, about 35%, about 40%, about 45%, about 50%, about 55%, about 60%, including ranges between any two of the above values.

FIG. 1 lists various B-AlHEA compositions including constituents shown in weight percentage based on the total weight of the B-AlHEA composition. For example, as illustrated in Examples 1-7 of FIG. 1, B-AlHEA composition may include a CoNiCrAlY alloy where a molar fraction of Al is between about 0.20 and about 0.25; at least one of cobalt boride (Co₂B) and molybdenum boride (Mo₂B); and a refractory alloy including molybdenum niobium (MoNb). The B-AlHEA compositions may include, based on the total weight of the B-AlHEA composition, between about 10% and about 70% by weight the CoNiCrAlY alloy; between about 20% and about 60% by weight at least one of Co₂B and Mo₂B; and between about 0.5% and about 10% by weight MoNb.

As illustrated in Examples 8-10, the refractory alloy may include M-Mo-Cr-Si, where M includes Ni or Co, and the compositions may include, based on the total weight of the composition, between about 30% and about 70% by weight the CoNiCrAlY alloy where a molar fraction of Al is between about 0.20 and about 0.25; between about 20% and about 40% by weight at least one of Co₂B and Mo₂B; and between about 20% and about 60% by weight M-Mo-Cr-Si, where M includes Ni or Co.

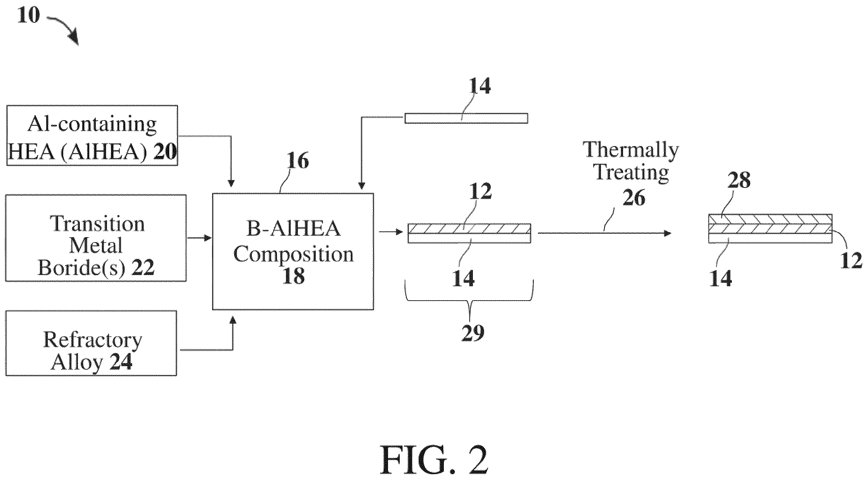

FIG. 2 is a schematic diagram of an embodiment of a process **10** for forming a B-AlHEA composition **18** and producing a coating **12** formed from B-AlHEA composition **18** on a substrate **14** (e.g., a machine component). Coating **12** enhances oxidation and mechanical wear resistance of substrate **14.** Substrate **14** may be a component of a gas turbine, such as part of a combustion section, bucket, bucket interlock, or another component of the gas turbine that may be subjected to ultra-high temperatures (e.g., greater than 800°C) and mechanical contact during operation. The steps illustrated in the process **10** are meant to serve the purpose of describing certain embodiments only and are not intended to limit the scope of this disclosure, because additional steps may be performed, certain steps may be omitted, and the illustrated steps may be performed in an alternative order or in parallel, where appropriate.

To start process **10,** at block **16,** a B-AlHEA composition **18** is formed. B-AlHEA composition **18** may be formed as a mixture of Al-containing high entropy alloy (AlHEA) **20,** transition metal boride(s) **22,** and a refractory alloy **24.** That is, B-AlHEA composition **18** may be formed by blending AlHEA **20** with transition metal boride(s) **22** and refractory alloy **24.** B-AlHEA composition may be formed as a mixture that includes, based on the total weight of the B-AlHEA composition, between about 10% and about 70% by weight AlHEA **20,** between about 20% and about 60% by weight transition metal boride(s) **22,** and between about 0.5% and about 60% by weight refractory alloy **24.** In some embodiments, AlHEA **20** includes a CoNiCrAlY alloy, where three or more elements of the CoNiCrAlY alloy are present in equimolar amounts, one of the three or more elements of the CoNiCrAlY alloy being Al, and a molar fraction of Al is between about 0.20 and about 0.25. Transition metal boride(s) **22** may include at least one of: cobalt boride (Co₂B), titanium boride (TiB₂), zirconium boride (ZrB₂), tantalum boride (TaB₂), niobium boride (NiB₂), or molybdenum boride (Mo₂B). In certain embodiments, transition metal boride(s) **22** may include at least one of cobalt boride (Co₂B) and molybdenum boride (Mo₂B). In certain embodiments, the refractory alloy may include molybdenum niobium (MoNb). In some embodiments, the refractory alloy may include M-Mo-Cr-Si, where M includes Ni or Co. In some embodiments, M-Mo-Cr-Si alloy may include Co-Mo-Cr-Si. In embodiments, the M-Mo-Cr-Si alloy may include T-800^{®}.

In embodiments, AlHEA **20,** transition metal boride(s) **22,** and/or refractory alloy **24** may be particles, where the particles may have a distribution of sizes (e.g., micron-sized particles, nanoparticles, or larger-sized particles) and shapes. For example, the micron-sized particles may be 10%, 20%, 30%, 40%, 50%, 60%, 70%, 80%, 90%, or 95% spherical, and the nano-size particles may be 10%, 20%, 30%, 40%, 50%, 60%, 70%, 80%, 90%, or 95% spherical.

B-AlHEA composition **18** may be provided in a powder form. The average particle size of B-AlHEA composition **18** may be measured by any currently known or later developed techniques for particle size analysis including, but are not limited to, dynamic light scattering (DLS), dynamic and static image analysis, sieve analysis, sedimentation, electrooptic scattering, and laser diffraction (LD), etc. If it is determined that the average particle size of B-AlHEA composition **18** is greater than a predefined average particle size range, B-AlHEA composition **18** may be further processed (e.g., high energy milling (ball / roller), vibro milling, etc.) to bring its average particle size to be within the predefined average particle size range. In certain embodiments, the predefined average particle size range is between about 0.1 microns (µm) and about 120 µm. Alternatively, one or more of AlHEA alloy **20,** transition metal boride(s) **22,** or refractory alloy **24** may be pre-processed (e.g., milling) to bring their respective average particle sizes to be within the predefined average particle size range of between about 0.1 microns (µm) and about 120 µm, before AlHEA alloy **20,** transition metal boride(s) **22,** and refractory alloy **24** are blended or mixed to form B-AlHEA composition **18.** After the process at block **16,** B-AlHEA composition **18** may be obtained in a powder blend having an average particle size range between about 0.1 µm and about 120 µm. In embodiments, the predefined average particle size range is between about 5 microns (µm) and about 70 µm, or between about 15 µm and about 45 µm, or preferably between about 25 µm and about 70 µm.

B-AlHEA composition **18** is then applied or deposited onto substrate **14,** such as to one or more surfaces of substrate **14.** In some embodiments, B-AlHEA composition **18** may be applied to the one or more surfaces of substrate **14** using any currently known or later developed deposition techniques including, but are not limited to, thermal spraying (e.g., plasma, flame, high velocity oxygen fuel (HVOF)), and high velocity air fuel (HVAF) spray), sputtering, and electron beam physical vapor deposition (EBPVD), etc.

The applying of B-AlHEA composition **18** onto substrate **14** (e.g., using a thermal spray) produces coating **12.** At step **26,** coating **12** is thermally treated (e.g., heated). Thermally treating coating **12** may precipitate sub-micrometric crystalline intermetallic phases (e.g., from B-AlHEA composition **18**) present in coating **12** and may provide enhanced wear resistance at temperatures greater than approximately 900°C. Thermally treating coating **12** can also generate an Al oxide layer **28** formed thereon. As will be discussed in detail with respect to FIG. 3, Al oxide layer **28** is an oxidation layer, which can act as a protective oxide layer to prevent the destruction of intermetallic phases, including laves phases present in coating **12,** under ultra-high temperatures. Al oxide layer **28** offers benefits of enhancing both oxidation resistance (for example, by minimizing oxidation of Cr and Co metals) and wear resistance (for example, by protecting laves phases underneath Al oxide layer **28** in the microstructure of the formed coating **12**).

Thermally treating coating **12** may include heating coating **12** (and substrate **14** or machine component **29** coated with coating **12**) to a relatively high temperature, such as approximately 500°C, 600°C, 700°C, 800°C, 900°C, or greater than 900°C for a predetermined time period. In certain embodiments, thermally treating coating **12** includes heating coating **12** to a temperature greater than 800°C for a predetermined time period. The predetermined time period may be 1 hour, 5 hours, 10 hours, 20 hours, or greater than 20 hours. At least in some instances, thermally treating coating **12** may include heating the coating **12** in a furnace capable of reaching the relatively high temperatures listed above. In some embodiments, thermally treating coating **12** may include operating the machine (e.g., the gas turbine) with one or more surfaces of the component of the machine coated with coating, and thus facilitating formation of Al oxide layer **28** during operation.

In certain embodiments, machine component **29** includes substrate **14** having coating **12** thereon. In embodiments, coating **12** includes: a CoNiCrAlY alloy, where three or more elements of the CoNiCrAlY alloy are present in equimolar amounts, one of the three or more elements of the CoNiCrAlY alloy being Al, and where a molar fraction of Al is between about 0.20 and about 0.25. The composition further includes a transition metal boride including at least one of: cobalt boride (Co₂B), titanium boride (TiB₂), zirconium boride (ZrB₂), tantalum boride (TaB₂), niobium boride (NiB₂), or molybdenum boride (Mo₂B), and a refractory alloy. Coating **12** may further include Al oxide layer **28** formed thereon.

FIG. 3 illustrates a schematic diagram of a microstructure **30** of a coating formed from B-AlHEA composition **18,** as embodied by the disclosure. Microstructure **30** may be evaluated using any currently known or later developed microstructural analysis techniques including, but are not limited to, scanning electron microscopy (SEM), optical microscope, etc. In FIG. 3, a non-limiting example is illustrated. In FIG. 3, microstructure **30** of coating **12** (FIG. 2) may include a sigma phase matrix **32,** a laves phase **34** uniformly dispersed in sigma phase matrix **32,** and a beta phase **36** dispersed in sigma phase matrix **32.** In some embodiments, sigma phase matrix **32** may include CoNiCrAlY alloy, where three or more elements are present in equimolar amounts, one of the three or more elements of the CoNiCrAlY alloy being Al, and a molar fraction of Al is between about 0.20 and about 0.25. Laves phase **34** may include a plurality of particles of transition metal boride(s) **38** (also see transition metal boride(s) **22,** FIG. 2). Beta phase **36** may include a plurality of particles of refractory alloy **24** (FIG. 2).

Microstructure **30** may further include an aluminum oxide layer **40** (also see Al oxide layer **28,** FIG. 2). As discussed with respect to FIG. 2, Al oxide layer **28, 40** may be formed when coating **12** is subjected to a temperature (e.g., greater than 800°C) for a predetermined time period. Al oxide layer **28, 40** may be formed above and across a region **42** of microstructure **30** that includes sigma phase matrix **32,** laves phase **34,** and beta phase **36.** Therefore, Al oxide layer **28, 40** may serve as a protective layer that protects the intermetallic phases in region **42** underneath Al oxide layer **28, 40.** For example, Al oxide layer **28, 40** protects laves phase **34** that includes a plurality of particles of transition metal boride(s) **22, 38,** thereby providing additional benefits of enhanced wear resistance under ultra-high temperatures. In some embodiments, Al oxide layer **28, 40** has a thickness of less than 20 µm. Furthermore, transition metal boride(s) **22, 38** may additionally provide enhanced wear resistance under ultra-high temperatures.

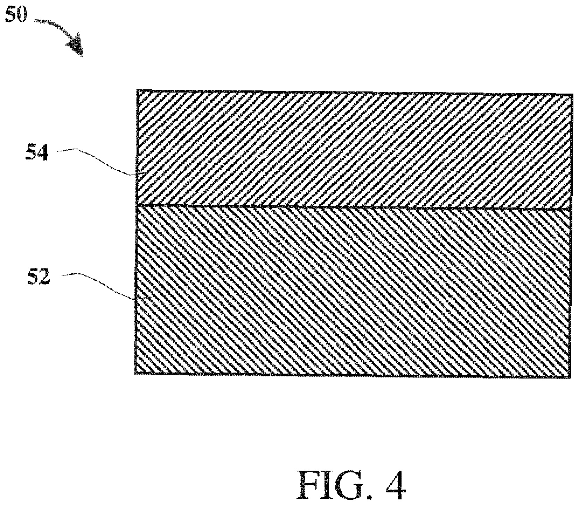

FIG. 4 is a schematic sectional view of a machine component **50** (also see machine component **29,** FIG. 2) including a substrate **52** having coating **54** thereon, according to the disclosure. Coating **54** (also see coating **12,** FIG. 2) is formed from B-AlHEA composition **18** (FIG. 2). Further, coating **12, 54** can be provided as a protective layer on substrate **52** (also see substrate **14,** FIG. 2). In certain embodiments, machine component **29, 50** includes substrate **14, 52** having a coating **12, 54** thereon. In some embodiments, coating **12, 54** include: a CoNiCrAlY alloy, where three or more elements of the CoNiCrAlY alloy are present in equimolar amounts, one of the three or more elements being Al, and a molar fraction of Al is between about 0.20 and about 0.25; a transition metal boride including at least one of: cobalt boride (Co₂B), titanium boride (TiB₂), zirconium boride (ZrB₂), tantalum boride (TaB₂), niobium boride (NiB₂), or molybdenum boride (Mo₂B), and a refractory alloy. Component **50** may be subjected to ultra-high temperatures, for example temperatures encountered by a hot gas path component in turbines. Turbines may include, but are not limited to, land-based gas turbines. Hot gas path components include, but are not limited to, combustion liners, transition pieces, turbine nozzles, and turbine blades (also known as "turbine buckets").

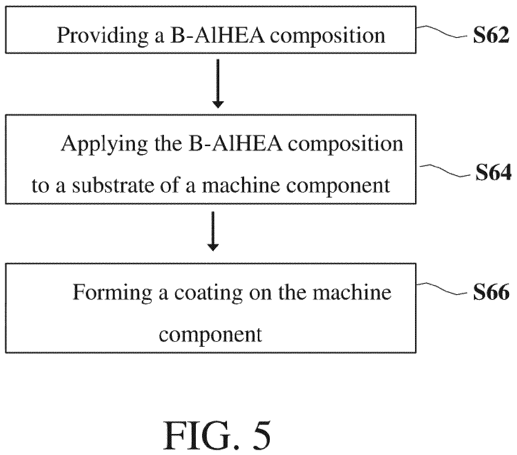

FIG. 5 is a flow diagram of a method of coating machine component **29, 50.** With further reference to FIGs. 2 and 4, the method includes providing B-AlHEA composition **18** at step **S62,** applying B-AlHEA composition **18** to substrate **14, 52** of machine component **29, 50** at step **S64,** and forming coating **12, 54** on substrate **14, 52** at step **S66.** The providing B-AlHEA composition **18** (step **S62**) further includes forming B-AlHEA composition **18** by mixing or blending the following: a CoNiCrAlY alloy, where three or more elements of the CoNiCrAlY alloy are present in equimolar amounts, one of the three or more elements being Al, and a molar fraction of Al is between about 0.20 and about 0.25; a transition metal boride including at least one of: cobalt boride (Co₂B), titanium boride (TiB₂), zirconium boride (ZrB₂), tantalum boride (TaB₂), niobium boride (NiB₂), or molybdenum boride (Mo₂B), and a refractory alloy. Forming B-AlHEA composition **18** may include controlling average particle size range of B-AlHEA composition **18** to be between about 0.1 µm and about 120 µm. Forming B-AlHEA composition **18** may optionally include adjusting (e.g., milling) particles of one or more of: the CoNiCrAlY alloy, the transition metal boride, and the refractory alloy, before mixing or blending such that each respective average particle size is within a preferred average particle size range of between about 0.1 µm and about 120 µm. In certain embodiments, B-AlHEA composition **18** is formed in a powder blend having an average particle size between about 0.1 microns (µm) and about 120 µm. In embodiments, the average particle size range is between about 5 microns (µm) and about 70 µm, or between about 15 µm and about 45 µm, or preferably between about 25 µm and about 70 µm.

With further reference to FIGs. 2 and 5, applying B-AlHEA composition **18** to substrate **14, 52** (step **S64**) may include applying or depositing B-AlHEA composition **18** onto one or more surfaces of substrate **14, 52** using currently known or later developed deposition techniques including, but are not limited to, thermal spraying (e.g., plasma, flame, and high velocity oxygen fuel (HVOF)), high velocity air fuel (HVAF) spray), sputtering, and electron beam physical vapor deposition (EBPVD), or combinations thereof.

Applying B-AlHEA composition **18** onto substrate **14, 52** (e.g., using a thermal spray) forms coating **12, 54.** Coating **12, 54** of machine component **29, 50** may include microstructure **30** (FIG. 3) that includes sigma phase matrix **32,** laves phase **34** uniformly dispersed in sigma phase matrix **32,** beta phase **36** dispersed in sigma phase matrix **32.** In some embodiments, sigma phase matrix **32** may include CoNiCrAlY alloy, where three or more elements of the CoNiCrAlY alloy are present in equimolar amounts, one of the three or more elements being Al, and a molar fraction of Al is between about 0.20 and about 0.25. Laves phase **34** may include a plurality of particles of transition metal boride(s) **38** (also see transition metal boride(s) **22,** FIG. 2), where transition metal boride(s) **22, 38** include at least one of: cobalt boride (Co₂B), titanium boride (TiB₂), zirconium boride (ZrB₂), tantalum boride (TaB₂), niobium boride (NiB₂), or molybdenum boride (Mo₂B). In embodiments, transition metal boride(s) **22, 38** include at least one of: cobalt boride (Co₂B) and molybdenum boride (Mo₂B). Beta phase **36** may include a plurality of particles of refractory alloy **24** (FIG. 2).

With further reference to FIGs. 2-4, forming coating **12, 54** on substrate **52** (**S66**) may additionally include thermally treating coating **12, 54** (e.g., heating) to generate Al oxide layer **28, 40.** Al oxide layer **28, 40** may be formed above and across a region **42** including sigma phase matrix **32,** laves phase **34,** and beta phase **36.** In some embodiments, Al oxide layer **28, 40** may have a thickness of less than about 20 µm.

Approximating language, as used herein throughout the specification and claims, may be applied to modify any quantitative representation that could permissibly vary without resulting in a change in the basic function to which it is related. Accordingly, a value modified by a term or terms, such as "about," "approximately" and "substantially," are not to be limited to the precise value as specified. In at least some instances, the approximating language may correspond to the precision of an instrument for measuring the value. Here and throughout the specification and claims, range limitations may be combined and/or interchanged; such ranges are identified and include all the sub-ranges contained therein unless context or language indicates otherwise. "Approximately" and "about," as applied to a particular value of a range, applies to both end values and, unless otherwise dependent on the precision of the instrument measuring the value, may indicate +/- 10% of the stated value(s).

## Claims

1. A composition (18), comprising:
a CoNiCrAlY alloy, wherein three or more elements of the CoNiCrAlY alloy are present in equimolar amounts, one of the three or more elements of the CoNiCrAlY alloy being aluminum (Al), and wherein a molar fraction of Al is between 0.20 and 0.25;
a transition metal boride including at least one of: cobalt boride,Co₂B, titanium boride, TiB₂, zirconium boride, ZrB₂, tantalum boride, TaB₂, niobium boride, NiB₂, or molybdenum boride, Mo₂B; and
a refractory alloy (24), wherein the refractory alloy (24) includes molybdenum niobium or M-Mo-Cr-Si, where M includes Ni or Co; and
wherein when the refractory alloy includes molybdenum niobium, MoNb, the composition includes, based on the total weight of the composition, between 10% and 70% by weight the CoNiCrAlY alloy, between 20% and 60% by weight the transition metal boride, and between 0.5% and 10% by weigh MoNb; or
wherein when the refractory alloy includes M-Mo-Cr-Si, where M includes Ni or Co, the composition includes, based on the total weight of the composition, between 30% and 70% by weight the CoNiCrAlY alloy, between 20% and 40% by weight the transition metal boride, and between 20% and 60% by weight the refractory alloy.

2. The composition (18) of any preceding claim, wherein the composition (18) includes a powder blend having an average particle size between 0.1 microns (µm) and 120 µm.

3. The composition (18) of any preceding claim, wherein the composition (18) is configured to form a coating (12, 54) having a microstructure (30) including:
a sigma phase matrix (32) including a plurality of particles of the CoNiCrAlY alloy;
a laves phase (34) uniformly dispersed in the sigma phase matrix (32), the laves phase (34) including a plurality of particles of the transition metal boride (22); and
a beta phase (36) dispersed in the sigma phase matrix (32), the beta phase (36) including a plurality of particles of the refractory alloy (24).

4. The composition (18) of claim 3, wherein the coating (12, 54) further includes an aluminum oxide layer (40) formed above and across a region (42), the region (42) including the sigma phase matrix (32), the laves phase (34), and the beta phase (36).

5. The composition (18) of claim 4, wherein the aluminum oxide layer (40) has a thickness of less than 20 microns (µm).

6. A machine component (29, 50) comprising:
a substrate (14, 52) having a coating (12, 54) thereon, the coating (12, 54) including:
a CoNiCrAlY alloy, wherein three or more elements of the CoNiCrAlY alloy are present in equimolar amounts, one of the three or more elements of the CoNiCrAlY alloy being Al, and wherein a molar fraction of Al is between 0.20 and 0.25;
a transition metal boride (22) including at least one of: cobalt boride, Co₂B, titanium boride, TiB₂, zirconium boride, ZrB₂, tantalum boride, TaB₂, niobium boride, NiB₂, or molybdenum boride, Mo₂B; and
a refractory alloy (24) ), wherein the refractory alloy (24) includes molybdenum niobium or M-Mo-Cr-Si, where M includes Ni or Co; and
wherein when the refractory alloy includes molybdenum niobium, the composition includes, based on the total weight of the composition, between 10% and 70% by weight the CoNiCrAlY alloy, between 20% and 60% by weight the transition metal boride, and between 0.5% and 10% by weigh MoNb; or
wherein when the refractory alloy includes M-Mo-Cr-Si, the composition includes, based on the total weight of the composition, between 30% and 70% by weight the CoNiCrAlY alloy, between 20% and 40% by weight the transition metal boride, and between 20% and 60% by weight the refractory alloy.

7. The machine component (29, 50) of any preceding claim, wherein the composition (18) includes a powder blend having an average particle size between 0.1 microns (µm) and 120 µm.

## Patentansprüche

1. Zusammensetzung (18), umfassend:
eine CoNiCrAlY-Legierung, wobei drei oder mehr Elemente der CoNiCrAlY-Legierung in äquimolaren Mengen vorhanden sind, wobei eines der drei oder mehr Elemente der CoNiCrAlY-Legierung Aluminium (Al) ist und wobei ein Molanteil von Al zwischen 0,20 und 0,25 liegt;
ein Übergangsmetallborid, das mindestens eines einschließt von: Kobaltborid,Co₂B, Titanborid, TiB₂, Zirkoniumborid, ZrB₂, Tantalborid, TaB₂, Niobborid, NiB₂ oder Molybdänborid, Mo₂B; und
eine hitzebeständige Legierung (24), wobei die hitzebeständige Legierung (24) Molybdän-Niob oder M-Mo-Cr-Si einschließt, wobei M Ni oder Co einschließt; und
wobei, wenn die hitzebeständige Legierung Molybdän-Niob, MoNb, einschließt, die Zusammensetzung, basierend auf dem Gesamtgewicht der Zusammensetzung, zu zwischen 10 Gew.-% und 70 Gew.-% die CoNiCrAlY-Legierung, zu zwischen 20 Gew.-% und 60 Gew.-% das Übergangsmetallborid und zu zwischen 0,5 Gew.-% und 10 Gew.-% MoNb einschließt; oder
wobei, wenn die hitzebeständige Legierung M-Mo-Cr-Si einschließt, wobei M Ni oder Co einschließt, die Zusammensetzung, basierend auf dem Gesamtgewicht der Zusammensetzung, zu zwischen 30 Gew.-% und 70 Gew.-% die CoNiCrAlY-Legierung, zu zwischen 20 Gew.-% und 40 Gew.-% das Übergangsmetallborid und zu zwischen 20 Gew.-% und 60 Gew.-% die hitzebeständige Legierung einschließt.

2. Zusammensetzung (18) nach einem der vorstehenden Ansprüche, wobei die Zusammensetzung (18) eine Pulvermischung einschließt, die eine durchschnittliche Partikelgröße zwischen 0,1 Mikrometer (µm) und 120 µm einschließt.

3. Zusammensetzung (18) nach einem der vorstehenden Ansprüche, wobei die Zusammensetzung (18) konfiguriert ist, um eine Beschichtung (12, 54) auszubilden, die eine Mikrostruktur (30) aufweist, die einschließt:
eine Sigma-Phasenmatrix (32), die eine Vielzahl von Partikeln der CoNiCrAlY-Legierung einschließt;
eine Laves-Phase (34), die gleichmäßig in der Sigma-Phasenmatrix (32) dispergiert ist, wobei die Laves-Phase (34) eine Vielzahl von Partikeln des Übergangsmetallborids (22) einschließt; und
eine Beta-Phase (36), die in der Sigma-Phasenmatrix (32) dispergiert ist, wobei die Beta-Phase (36) eine Vielzahl von Partikeln der hitzebeständigen Legierung (24) einschließt.

4. Zusammensetzung (18) nach Anspruch 3, wobei die Beschichtung (12, 54) ferner eine Aluminiumoxidschicht (40) einschließt, die oberhalb des und über einen Bereich (42) ausgebildet ist, wobei der Bereich (42) die Sigma-Phasenmatrix (32), die Laves-Phase (34) und die Beta-Phase (36) einschließt.

5. Zusammensetzung (18) nach Anspruch 4, wobei die Aluminiumoxidschicht (40) eine Dicke von weniger als 20 Mikrometer (µm) aufweist.

6. Maschinenkomponente (29, 50), umfassend:
ein Substrat (14, 52), das eine Beschichtung (12, 54) darauf aufweist, wobei die Beschichtung (12, 54) einschließt:
eine CoNiCrAlY-Legierung, wobei drei oder mehr Elemente der CoNiCrAlY-Legierung in äquimolaren Mengen vorhanden sind, wobei eines der drei oder mehr Elemente der CoNiCrAlY-Legierung Al ist und wobei ein Molanteil von Al zwischen 0,20 und 0,25 liegt;
ein Übergangsmetallborid (22), das mindestens eines einschießt von: Kobaltborid, Co₂B, Titanborid, TiB₂, Zirkoniumborid, ZrB₂, Tantalborid, TaB₂, Niobborid, NiB₂ oder Molybdänborid, Mo₂B; und
eine hitzebeständige Legierung (24), wobei die hitzebeständige Legierung (24) Molybdän-Niob oder M-Mo-Cr-Si einschließt, wobei M Ni oder Co einschließt; und
wobei, wenn die hitzebeständige Legierung Molybdän-Niob einschließt, die Zusammensetzung, basierend auf dem Gesamtgewicht der Zusammensetzung, zu zwischen 10 Gew.-% und 70 Gew.-% die CoNiCrAlY-Legierung, zu zwischen 20 Gew.-% und 60 Gew.-% das Übergangsmetallborid und zu zwischen 0,5 Gew.-% und 10 Gew.-% MoNb einschließt; oder
wobei, wenn die hitzebeständige Legierung M-Mo-Cr-Si einschließt, die Zusammensetzung, basierend auf dem Gesamtgewicht der Zusammensetzung, zu zwischen 30 Gew.-% und 70 Gew.-% die CoNiCrAlY-Legierung, zu zwischen 20 Gew.-% und 40 Gew.-% das Übergangsmetallborid und zu zwischen 20 Gew.-% und 60 Gew.-% die hitzebeständige Legierung einschließt.

7. Maschinenkomponente (29, 50) nach einem der vorstehenden Ansprüche, wobei die Zusammensetzung (18) eine Pulvermischung einschließt, die eine durchschnittliche Partikelgröße zwischen 0,1 Mikrometer (µm) und 120 µm einschließt.

## Revendications

1. Composition (18), comprenant :
un alliage CoNiCrAIY, dans laquelle trois éléments ou plus de l'alliage CoNiCrAIY sont présents en quantités équimolaires, l'un des trois éléments ou plus de l'alliage CoNiCrAlY étant l'aluminium (AI), et dans laquelle une fraction molaire d'AI est comprise entre 0,20 et 0,25 ;
un borure de métal de transition comportant au moins un parmi : borure de cobalt, Co₂B, borure de titane, TiB₂, borure de zirconium, ZrB₂, borure de tantale, TaB₂, borure de niobium, NiB₂, ou borure de molybdène, Mo₂B ; et
un alliage réfractaire (24), dans laquelle l'alliage réfractaire (24) comporte du molybdène-niobium ou M-Mo-Cr-Si, où M comporte Ni ou Co ; et
dans laquelle, lorsque l'alliage réfractaire comporte du molybdène-niobium, MoNb, la composition comporte, sur la base du poids total de la composition, 10 % à 70 % en poids d'alliage CoNiCrAIY, 20 % à 60 % en poids de borure de métal de transition, et 0,5 % à 10 % en poids de MoNb ; ou
dans laquelle, lorsque l'alliage réfractaire comporte M-Mo-Cr-Si, où M comporte Ni ou Co, la composition comporte, sur la base du poids total de la composition, 30 % à 70 % en poids d'alliage CoNiCrAlY, 20 % à 40 % en poids de borure de métal de transition, et 20 % à 60 % en poids d'alliage réfractaire.

2. Composition (18) selon l'une quelconque revendication précédente, dans laquelle la composition (18) comporte un mélange de poudre présentant une taille moyenne de particules entre 0,1 micron (µm) et 120 µm.

3. Composition (18) selon l'une quelconque revendication précédente, dans laquelle la composition (18) est configurée pour former un revêtement (12, 54) ayant une microstructure (30) comportant :
une matrice de phase sigma (32) comportant une pluralité de particules de l'alliage CoNiCrAlY ;
une phase de laves (34) uniformément dispersée dans la matrice de phase sigma (32), la phase de laves (34) comportant une pluralité de particules du borure de métal de transition (22) ; et
une phase bêta (36) dispersée dans la matrice de phase sigma (32), la phase bêta (36) comportant une pluralité de particules de l'alliage réfractaire (24).

4. Composition (18) selon la revendication 3, dans laquelle le revêtement (12, 54) comporte en outre une couche d'oxyde d'aluminium (40) formée au-dessus et à travers une région (42), la région (42) comportant la matrice de phase sigma (32), la phase de laves (34) et la phase bêta (36).

5. Composition (18) selon la revendication 4, dans laquelle la couche d'oxyde d'aluminium (40) présente une épaisseur inférieure à 20 microns (µm).

6. Composant de machine (29, 50) comprenant :
un substrat (14, 52) ayant un revêtement (12, 54) sur celui-ci, le revêtement (12, 54) comportant :
un alliage CoNiCrAIY, dans lequel trois éléments ou plus de l'alliage CoNiCrAIY sont présents en quantités équimolaires, l'un des trois éléments ou plus de l'alliage CoNiCrAlY étant l'Al, et dans lequel une fraction molaire d'AI est comprise entre 0,20 et 0,25 ;
un borure de métal de transition (22) comportant au moins l'un parmi : borure de cobalt, Co₂B, borure de titane, TiB₂, borure de zirconium, ZrB₂, borure de tantale, TaB₂, borure de niobium, NiB₂, ou borure de molybdène, Mo₂B ; et
un alliage réfractaire (24), dans lequel l'alliage réfractaire (24) comporte du molybdène-niobium ou M-Mo-Cr-Si, où M comporte Ni ou Co ; et
dans lequel, lorsque l'alliage réfractaire comporte du molybdène-niobium, la composition comporte, sur la base du poids total de la composition, 10 % à 70 % en poids d'alliage CoNiCrAlY, 20 % à 60 % en poids de borure de métal de transition, et 0,5 % à 10 % en poids de MoNb ; ou
dans lequel, lorsque l'alliage réfractaire comporte M-Mo-Cr-Si, la composition comporte, sur la base du poids total de la composition, 30 % à 70 % en poids d'alliage CoNiCrAlY, 20 % à 40 % en poids de borure de métal de transition, et 20 % à 60 % en poids d'alliage réfractaire.

7. Composant de machine (29, 50) selon l'une quelconque revendication précédente, dans lequel la composition (18) comporte un mélange de poudre présentant une taille moyenne de particules entre 0,1 micron (µm) et 120 µm.
